# EUROPEAN PATENT SPECIFICATION

(11) **EP 3 783 507 B1**
(45) Date of publication and mention of the grant of the patent: **26.06.2024**
(21) Application number: 18933235.6
(22) Date of filing: 27.12.2018
(51) Int. Cl.: G06F 17/00, F24F 11/48, F24F 11/62, F24F 11/79, G06F 3/01, F24F 1/0011, F24F 13/10

(54) **METHOD FOR DETERMINING AIR BLOWING ANGLE RANGE OF AIR CONDITIONER**
VERFAHREN ZUR BESTIMMUNG DES LUFTBLASWINKELBEREICHS EINER KLIMAANLAGE
PROCÉDÉ PERMETTANT DE DÉTERMINER LA PLAGE D'ANGLE DE SOUFFLAGE D'AIR DE CLIMATISEUR

(30) Priority: 12.09.2018 CN 201811063722
(43) Date of publication of application: 24.02.2021
(73) Proprietor: Gree Electric Appliances, Inc. of Zhuhai, Zhuhai, Guangdong 519070 (CN)
(72) Inventor: ZHANG, Xin, Zhuhai, Guangdong 519070 (CN); WANG, Huijun, Zhuhai, Guangdong 519070 (CN); LI, Baoshui, Zhuhai, Guangdong 519070 (CN); LIU, Jianjun, Zhuhai, Guangdong 519070 (CN); LIAO, Hufeng, Zhuhai, Guangdong 519070 (CN); MAO, Yuehui, Zhuhai, Guangdong 519070 (CN); LIU, Demao, Zhuhai, Guangdong 519070 (CN)
(74) Representative: Appleyard Lees IP LLP
(86) International application number: PCT/CN2018/124427
(87) International publication number: WO 2020/052167

(56) References cited:
- CN-A- 1 912 485
- CN-A- 105 805 914
- CN-A- 106 440 201
- CN-A- 106 440 201
- JP-A- 2016 080 196
- KR-A- 20180 024 264
- US-B2- 7 206 724

## Description

### TECHNICAL FIELD

The present invention relates to the field of smart home appliance technology, and to a method for determining an air-blowing opening angle of an air conditioner.

### BACKGROUND

In daily life, along with the growth of the necessities of life, demands for functions of air conditioners have also become tremendous. For example, in some daily life, blown air of the air conditioning is needed to follow the movement of people to achieve the purpose of cooling users as soon as possible. In another case, the blown air of the air conditioner is needed to be prevented from blowing towards people, so as to prevent users from catching a cold. However, the functions of air conditioner of wind-following-people and wind-avoiding-people are generally affected by an air-blowing opening angle of the air conditioner. The air-blowing opening angle of the air conditioner is configured to determine an air blowing range of the air conditioner. In general, a placement position of the air conditioner in room or in other environments can be determined on the basis of the air-blowing opening angle of the air conditioner.

Document CN106440201A discloses an air-conditioning method, a device, and an air-conditioning. In related technologies, in one case, a sensor is commonly arranged in a room or in an environment in which the air conditioner is located, to measure the air-blowing opening angle of the air conditioner, thereby adjusting the placement position of the air conditioner. However, the fact that the sensor needed to be installed in the process increases the cost of hardware. In another case, a suitable placement position of the air conditioner is determined by measurement tools based on the location of the air conditioner, the dimensions of the room, and parameters of the air-blowing opening angle corresponding to the air-conditioner model. Due to the hardware differences of different air conditioners, there is a difference between an actual air-blowing opening angle and a predicted air-blowing opening angle, thus resulting in inaccurate calculation results.

Alternatively, the placement of the air conditioner includes not only the placement location of the air conditioner, but also the placement angle of the air conditioner. The placement angle of the air conditioner will also play a vital role in the user's experience in future use. In a case that the user does not know the air-blowing opening angle, it is difficult for the user to place the air conditioner at a suitable placement location and at a suitable placement angle. As a result, the air-blowing opening angle of the air conditioner is small, which causes a problem of poor user's experience and waste of energy consumption of the air conditioner.

In view of the above problems, no effective solutions have been proposed yet.

### SUMMARY

The present invention is defined by a method according to claim 1. Embodiments of the present invention provide a method and a device for determining an air-blowing opening angle of an air conditioner, and an air conditioner, to solve at least the technical problem in the prior art that certain functions of the air conditioner cannot be achieved because the air-blowing opening angle of the air conditioner cannot be accurately measured.

According to the present invention, a method for determining an air-blowing opening angle of an air conditioner according to claim 1 is provided. In particular, it includes:
establishing a space coordinate system of an environment, in which the air conditioner is located, according to parameter information of the air conditioner and an image of the environment in which the air conditioner is located, wherein an image acquisition device of an augmented reality terminal acquires the image of the environment in which the air conditioner is located; determining coordinates of the air conditioner and the augmented reality terminal in the space coordinate system respectively; adjusting an air blowing angle of an air outlet of the air conditioner; moving the augmented reality terminal within an air blowing range at each maximum air blowing angle of the air outlet, and obtaining a position change of the augmented reality terminal; and determining an air-blowing opening angle of the air conditioner according to the position change of the augmented reality terminal.

In an embodiment of the invention, in an augmented-reality application of the augmented reality terminal, the establishing the space coordinate system of the environment, in which the air conditioner is located, according to the parameter information of the air conditioner and the image of the environment in which the air conditioner is located, include: obtaining an image of the air conditioner and the image of the environment in which the air conditioner is located; analyzing an air conditioner identifier in the image of the air conditioner, and obtaining the parameter information of the air conditioner, the parameter information being contained in the air conditioner identifier; and establishing the space coordinate system according to the image of the environment in which the air conditioner is located.

In an embodiment of the invention, the adjusting the air blowing angle of the air outlet of the air conditioner, includes: determining, when each air blowing angle of the air conditioner arrives at a maximum, a position change of the augmented reality terminal within a current air blowing range of the air conditioner; determining boundary coordinates of the augmented reality terminal within the air blowing range of each maximum air blowing angle of the air outlet; and determining the air-blowing opening angle of the air conditioner based on the boundary coordinates of the augmented reality terminal within each maximum air blowing angle of the air outlet.

In an embodiment of the invention, the method further includes: determining an air blowing mode of the air conditioner, the air blowing mode comprising a first air blowing mode and a second air blowing mode; obtaining a current position coordinate of the augmented reality terminal; adjusting, when the air blowing mode is the first air blowing mode, the air blowing angle of the air conditioner according to the position coordinate of the augmented reality terminal, making the position coordinate of the augmented reality terminal to be located within the air blowing range of the air conditioner; and adjusting, when the air blowing mode is the second air blowing mode, the air blowing angle of the air conditioner according to the position coordinate of the augmented reality terminal, making the position coordinate of the augmented reality terminal to be located outside the air blowing range of the air conditioner.

In an embodiment of the invention, the method further includes: determining a distance between the air conditioner and the augmented reality terminal; setting, when the distance exceeds a preset distance, the air blowing mode of the air conditioner to a third air blowing mode; and setting, when the distance does not exceed the preset distance, the air blowing mode of the air conditioner to a fourth air blowing mode; wherein an air speed in the third air blowing mode is greater than an air speed in the fourth air blowing mode.

In an embodiment of the invention, after the determining the air-blowing opening angle of the air conditioner according to the position change of the augmented reality terminal, the method further includes: determining, in the space coordinate system, a target coordinate of a target air-blowing position in the environment in which the air conditioner is located; and determining a best placement position of the air conditioner according to the air-blowing opening angle of the air conditioner and the target coordinate; wherein the target air-blowing position is located within the air blowing range of the air conditioner.

In an embodiment of the invention, the determining the best placement position of the air conditioner according to the air-blowing opening angle of the air conditioner and the target coordinate, includes: adjusting a position coordinate of the air conditioner based on a position relationship between the air blowing range and the target coordinate; and determining, when the target coordinate falls within the air blowing range, a current coordinate of the air conditioner in the space coordinate system to be the best placement position.

Preferably, the air blowing mode comprises a temperature, and a temperature in the third air blowing mode is greater than a temperature in the fourth air blowing mode.

Preferably, a humidity in the third air blowing mode is greater than a humidity in the fourth air blowing mode.

In an embodiment of the invention, after the determining the air-blowing opening angle of the air conditioner according to the position change of the augmented reality terminal, the method further includes: determining, in the coordinate system, a coordinate of an air blowing target in the environment in which the air conditioner is located; and determining a best placement angle of the air conditioner according a placement position of the air conditioner, the air-blowing opening angle, a position of the air outlet, and the coordinate of the air blowing target; wherein a target air-blowing position of the air blowing target is located within the air blowing range of the air conditioner.

In the embodiments of the present invention, according to the parameter information of the air conditioner and the image of the environment in which the air conditioner is located, the space coordinate system of the environment, in which the air conditioner is located, is established. The coordinates of the air conditioner and the augmented reality terminal in the space coordinate system are determined respectively. The air blowing angle of the air outlet of the air conditioner is adjusted, and the augmented reality terminal is moved within the air blowing range of each maximum air blowing opening angle of the air outlet, thereby obtaining the position change of the augmented reality terminal. The air conditioner and the environment in which the air conditioner is located are modeled by using the modeling method using the augmented-reality technology. Then, the air blowing range of the air conditioner is measured on the basis of the augmented reality terminal, thereby achieving the objective of determining the air blowing range of the air conditioner under measurement, determining the air-blowing opening angle of the air conditioner under measurement, and solving the technical problem in the prior art that certain functions of the air conditioner cannot be achieved because the air-blowing opening angle of the air conditioner cannot be accurately measured.

### BRIEF DESCRIPTION OF THE DRAWINGS

The drawings described herein are used to provide a further understanding of the invention and constitute a part of the invention. The exemplary embodiments and description of the invention are used to explain the invention, but do not constitute an improper limitation to the invention. In the drawings:
FIG. 1 is a schematic diagram illustrating an application scene for an alternative method for determining an air-blowing opening angle of an air conditioner according to some embodiments of the present invention;
FIG. 2 is a schematic diagram illustrating an alternative method for determining an air-blowing opening angle of the air conditioner according to some embodiments of the present invention;
FIG. 3 is a schematic diagram illustrating an alternative space coordinate system according to some embodiments of the present invention;
FIG. 4 is a schematic diagram illustrating alternative left and right opening angles of the air conditioner according to some embodiments of the present invention;
FIG. 5 is a schematic diagram illustrating alternative upper and lower opening angles of the air conditioner according to some embodiments of the present invention;
FIG. 6 is a schematic diagram illustrating that a maximum air blowing angle of the air conditioner is positioned by an alternative mobile terminal according to some embodiments of the present invention;
FIG. 7 is a schematic diagram illustrating an alternative augmented-reality application in the mobile terminal displaying the air-blowing opening angle of the air conditioner according to some embodiments of the present invention;
FIG. 8 is a schematic diagram illustrating an alternative first air blowing mode of the air conditioner according to some embodiments of the present invention;
FIG. 9 is a schematic diagram illustrating an alternative second air blowing mode of the air conditioner according to some embodiments of the present invention;
FIG. 10 is a schematic diagram illustrating an alternative placement angle of the air conditioner according some embodiments of the present invention;

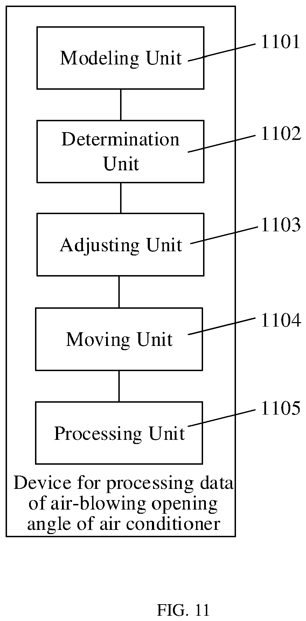

FIG. 11 is a diagram illustrating a structure of an alternative device for determining an air-blowing opening angle of the air conditioner according to some embodiments of the present invention.

### DETAILED DESCRIPTION OF THE EMBODIMENTS

It should be specified that the terms "first", "second", etc. in the description, the claims and the drawings in the present invention are just used to distinguish similar objects, but not used to describe a specific order or an order of priority. It should be understood that such terms may be interchangeable under appropriate conditions, such that the embodiments of the present invention illustrated in the drawing or described herein can be implemented, for example, in a sequence other than the sequences illustrated or described herein. In addition, the terms "comprise", "have" and any variations thereof are intended to cover a non-exclusive inclusion. For example, a process, a method, a system, a product, or a device that includes a series of steps or units is not limited to those steps or units listed clearly, but may include other steps or units, which are not clearly listed, or which are inherent to such a process, a method, a product or a device.

### First Embodiment

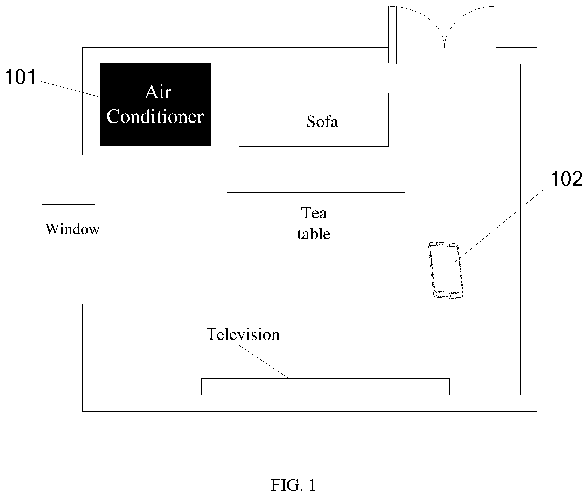

Embodiments of the method for determining an air-blowing opening angle of the air conditioner according to the invention are provided. As an embodiment, the method for determining an air-blowing opening angle of the air conditioner can be applied to, but is not limited to, the application environment shown in FIG. 1. Where, an augmented reality terminal 102 is arranged in a room in which an air conditioner 101 is located. A space coordinate system of the room is established according to parameter information of the air conditioner 101 and an image of the current room. Coordinates of the air conditioner 101 and the augmented reality terminal 102 in the space coordinate system are respectively determined. An air blowing angle of an air outlet of the air conditioner 101 is adjusted. The augmented reality terminal 102 is moved within an air blowing range of the air conditioner 101 when the air blowing angle of the air outlet of the air conditioner 101 arrives at a maximum in each air blowing direction, so as to obtain a position change of the augmented reality terminal 102. The air-blowing opening angle of the air conditioner 101 is determined according to the position change of the augmented reality terminal 102.

In some embodiments, the augmented reality terminal includes, but is not limited to, a mobile terminal (such as, a mobile phone, a tablet, or the like) provided with an augmented reality application, an augmented-reality helmet, and a pair of augmented-reality glasses.

In some embodiments of the present invention, the space coordinate system is established on the basis of the augmented reality technology, and by obtaining the parameter information of the air conditioner 101 and information like the image of the environment in which the air conditioner 101 is located. Then, the position of the augmented reality terminal 102 is determined on the basis of the augmented reality technology. Alternatively, the space coordinate system can be established in the augmented reality application of the augmented reality terminal 102, in the augmented reality application of a separated augmented reality terminal, or in a cloud server of an augmented reality application. The above embodiment is only an example, but not a limitation.

It should also be noted that the parameter information of the air conditioner includes, but is not limited to, a volume model of the air conditioner, which includes specifications of the air conditioner, the position of the air outlet of the air conditioner, the maximum air blowing angles, and the like. The air conditioner model of the air conditioner can be established in the space coordinate system based on the parameter information of the air conditioner.

In some embodiments, the air outlet of the air conditioner has a plurality of air blowing directions. For example, in the actual application scene, the air conditioner usually includes four air blowing directions: an upper opening angle, a lower opening angle, a left opening angle, and a right opening angle. In some embodiments, in order to determine the air-blowing opening angle of the air conditioner, it is needed to measure the air blowing range of the blown air of the air conditioner by moving the augmented reality terminal when each air blowing direction of the air conditioner arrives at a maximum air blowing angle. In the process of determining the air blowing range of the air conditioner by the augmented reality terminal, the augmented reality terminal is provided with an air speed sensor and a temperature sensor in advance, so as to determine the air blowing range of the air conditioner. In another case, since air blowing of the air conditioner is affected by distances and perception differences of different users, alternatively, the process of determining the air blowing range of the air conditioner by the augmented reality terminal can also be performed by the user holding the augmented reality terminal, to determine the air blowing range of the air conditioner by means of the body surface perception of the user, thereby further determining the air-blowing opening angle of the air conditioner.

In the embodiments, according to the parameter information of the air conditioner and the image of the environment in which the air conditioner is located, the space coordinate system of the environment, in which the air conditioner is located, is established. The coordinates of the air conditioner and the augmented reality terminal in the space coordinate system are determined respectively. The air blowing angle of the air outlet of the air conditioner is adjusted, and the augmented reality terminal is moved within the air blowing range of each maximum air blowing opening angle of the air outlet, so as to obtain the position change of the augmented reality terminal, thereby achieving the purpose of determining the air blowing range of the air conditioner, thereby determining the air-blowing opening angle of the air conditioner.

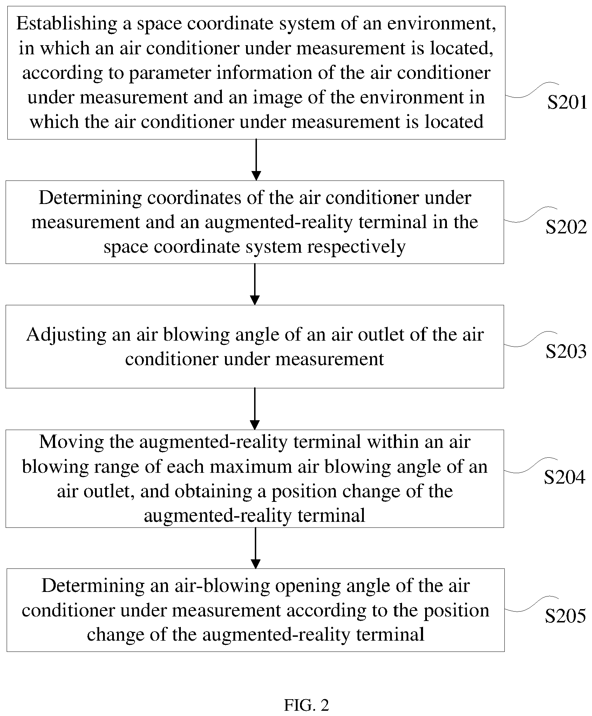

According to the embodiments of the present invention, a method for determining an air-blowing opening angle of an air conditioner is provided. As shown in FIG. 2, the method includes:
S201, establishing a space coordinate system of an environment, in which an air conditioner is located, according to parameter information of the air conditioner and an image of the environment in which the air conditioner is located;
S202, determining coordinates of the air conditioner and an augmented reality terminal in the space coordinate system respectively;
S203, adjusting an air blowing angle of an air outlet of the air conditioner;
S204, moving the augmented reality terminal within an air blowing range of each maximum air blowing angle of the air outlet, and obtaining a position change of the augmented reality terminal;
S205, determining an air-blowing opening angle of the air conditioner according to the position change of the augmented reality terminal.

In some embodiments, the parameter information of the air conditioner can is obtained through an air conditioner identifier carried by the air conditioner itself. By analyzing the air conditioner identifier, such as a Quick Response code, of the air conditioner, the parameter information of the air conditioner can be obtained. On another hand, by matching the image of the air conditioner on the Internet, the parameter information corresponding to the image of the air conditioner is obtained. Moreover, it is also possible to obtain the air conditioner model pre-labeled on the air conditioner, and in turn request the server in the air conditioner information for the parameter information corresponding to the air conditioner model according to the air conditioner model. The above is only an example, but not any limitation to the method of the embodiments.

After the space coordinate system of the environment, in which the air conditioner is located, is located according to the parameter information of the air conditioner and the image of the environment in which the air conditioner, the coordinates of the air conditioner and the augmented reality terminal in the space coordinate system are determined. An image acquisition device of the augmented reality terminal is used to acquire the image of the environment in which the air conditioner is located, so as to create the air conditioner model of the air conditioner and establish the space coordinate system, and in turn determine the coordinates of the air conditioner and the augmented reality terminal in the space coordinate system.

After the space coordinate system of the environment in which the air conditioner is located is established, the air blowing angle of the air outlet of the air conditioner is adjusted, and the augmented reality terminal is moved within the air blowing range of each maximum air blowing angle of the air outlet. The air conditioner includes a plurality of air blowing directions. The above-mentioned each maximum air blowing angle of the air conditioner is actually the maximum air blowing angle in each of the plurality of air blowing directions of the air conditioner. For example, in the air blowing direction of the lower opening angle, the air outlet of the air conditioner is adjusted to the maximum air blowing angle. At the moment, the air blowing range at this air blowing angle of the air conditioner can be measured by moving the augmented reality terminal. The position change of the augmented reality terminal can be obtained by moving the augmented reality terminal within the air blowing range of each maximum air blowing angle of the air outlet under measurement. The position change is a moving track of the coordinate of the augmented reality terminal. In an embodiment, the air-blowing opening angle of the air conditioner is determined according to the moving track of the coordinate of the augmented reality terminal.

It should be noted that according to the embodiments, the air conditioner and the environment, in which the air conditioner is located, are modeled by a modeling method using the augmented-reality technology. Then, the air blowing range of the air conditioner is measured on the basis of the augmented reality terminal, thereby achieving the purpose of determining the air blowing range of the air conditioner, determining the air-blowing opening angle of the air conditioner, and solving the technical problem in the prior art that certain functions of the air conditioner cannot be achieved because the air-blowing opening angle of the air conditioner cannot be accurately measured.

In some embodiments, in the augmented-reality application of the augmented reality terminal, the establishing the space coordinate system of the environment, in which the air conditioner is located, according to the parameter information of the air conditioner and the image of the environment in which the air conditioner is located, includes, but is not limited to: obtaining an image of the air conditioner and the image of the environment in which the air conditioner is located; analyzing an air conditioner identifier in the image of the air conditioner, and obtaining the parameter information of the air conditioner under measurement, which is contained in the air conditioner identifier; establishing the space coordinate system according to the image of the environment in which the air conditioner is located.

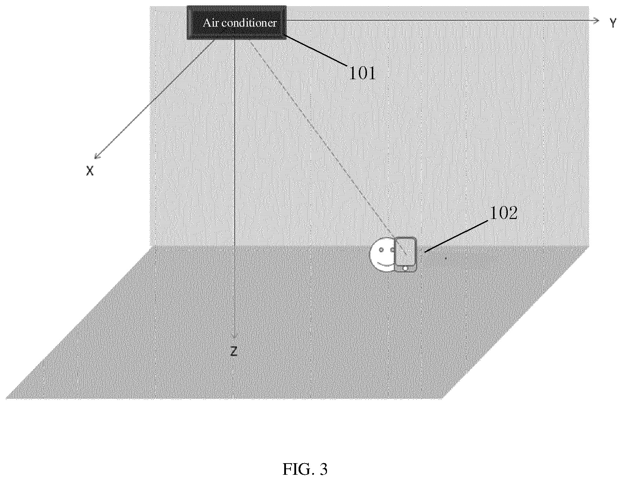

In some embodiments, taking the application scene shown in FIG. 1 as an example, the image of the air conditioner and the image of the current environment, namely, a room layout shown in FIG. 1, is obtained firstly. The air conditioner shown in FIG. 1 is a suspended air conditioner. The parameter information of the air conditioner, such as a recommended suspension height of the suspended air conditioner, an effective air blowing range, and the like, can be obtained through the air conditioner identifier on the suspended air conditioner. Then, the space coordinate system shown in FIG. 3 is established, where, the air conditioner is used as a coordinate origin of the spatial coordinate system.

In some embodiments, the adjusting the air blowing angle of the air outlet of the air conditioner, includes, but is not limited to: adjusting the air blowing angle of the air conditioner; determining, when each air blowing angle of the air conditioner arrives at the maximum, the position change of the augmented reality terminal within the current air blowing range of the air conditioner; determining boundary coordinates of the augmented reality terminal within the air blowing range of each maximum air blowing angle of the air outlet; determining the air-blowing opening angle of the air conditioner based on the boundary coordinates of the augmented reality terminal in each maximum air blowing angle of the air outlet.

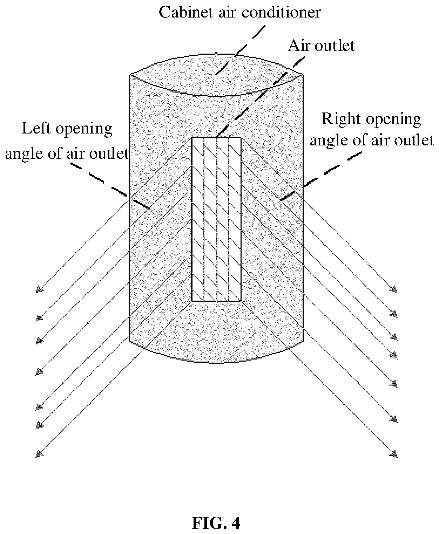

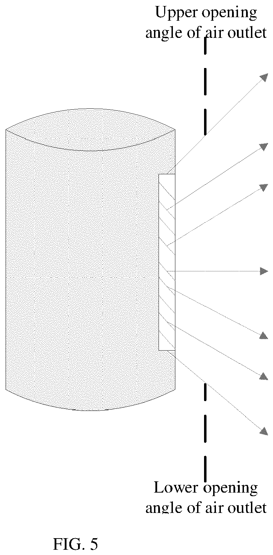

It should be noted that in the embodiments, the air outlet of the air conditioner has a plurality of air blowing angles. For example, when the air conditioner is a conventional cabinet air conditioner, the air outlet has four air blowing angles including "a left opening angle", "a right opening angle", "an upper opening angle", and "a lower opening angle". FIG. 4 is a schematic diagram illustrating the left and right opening angles of the air outlet of the air conditioner, and FIG. 5 is a schematic diagram illustrating the upper and lower opening angles of the air outlet of the air conditioner.

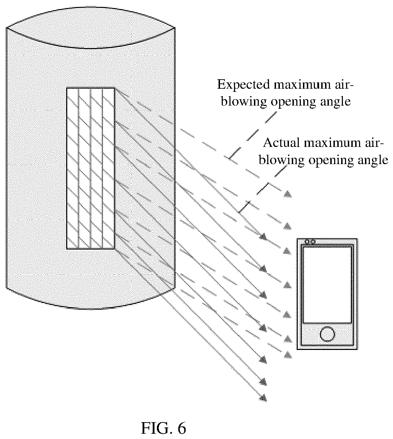

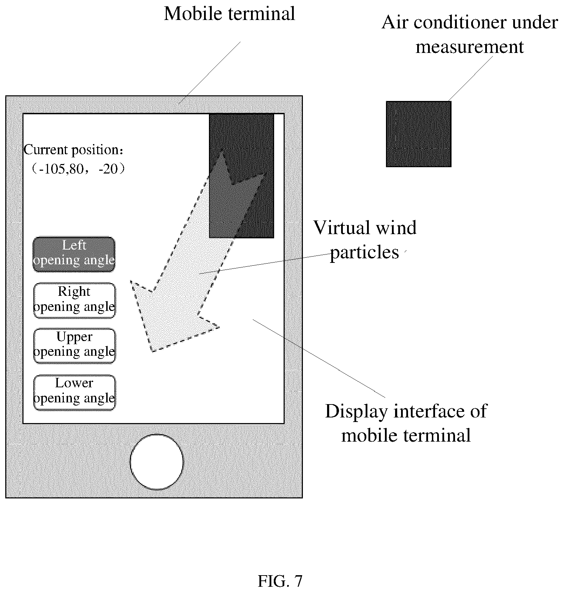

In another embodiment, FIG. 6 is a schematic diagram illustrating that the maximum air blowing angle of the air conditioner is positioned by the mobile terminal. The air outlet of the air conditioner is adjusted to an air blowing angle of the "left opening angle" in an interface of the air conditioner, which is used for controlling the air-blowing opening angle of the air conditioner. FIG. 7 is a schematic diagram illustrating an augmented-reality application in the mobile terminal displaying the air-blowing opening angle of the air conditioner. The left most boundary coordinate of the air conditioner in the air blowing angle of the "left opening angle" of the air outlet is determined on the basis of the range of in the maximum air blowing angle of the "left opening angle" of the air outlet. In the augmented-reality application in the mobile terminal, the boundary coordinate (-105, -80, 20) of the augmented reality terminal is displayed at this moment, and this boundary coordinate is the boundary coordinate of the "left opening angle" of the air outlet of the air conditioner. Similarly, the boundary coordinates of other air blowing angles of the air conditioner can be obtained by means of the same method, and the boundary coordinates of the other air blowing angles are combined to obtain the air-blowing opening angle of the air conditioner.

In some embodiments, the above-mentioned method further includes, but is not limited to: determining an air blowing mode of the air conditioner, the air blowing mode including a first air blowing mode and a second air blowing mode; obtaining a current position coordinate of the augmented reality terminal; adjusting, when the air blowing mode is the first air blowing mode, the air blowing angle of the air conditioner according to the position coordinate of the augmented reality terminal, and making the position coordinate of the augmented reality terminal to be located within the air blowing range of the air conditioner; adjusting, when the air blowing mode is the second air blowing mode, the air blowing angle of the air conditioner according to the position coordinate of the augmented reality terminal, and making the position coordinate of the augmented reality terminal to be located outside the air blowing range of the air conditioner.

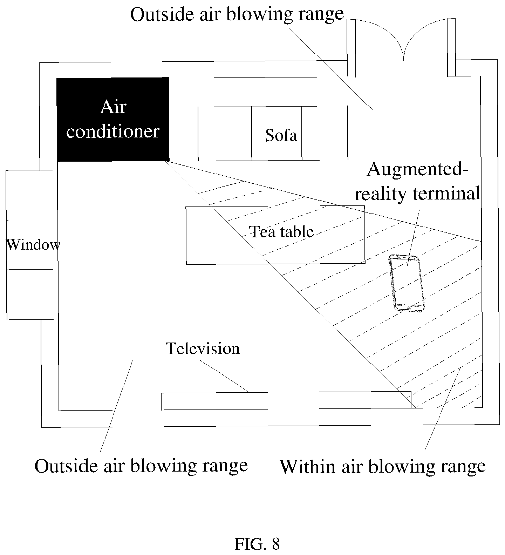

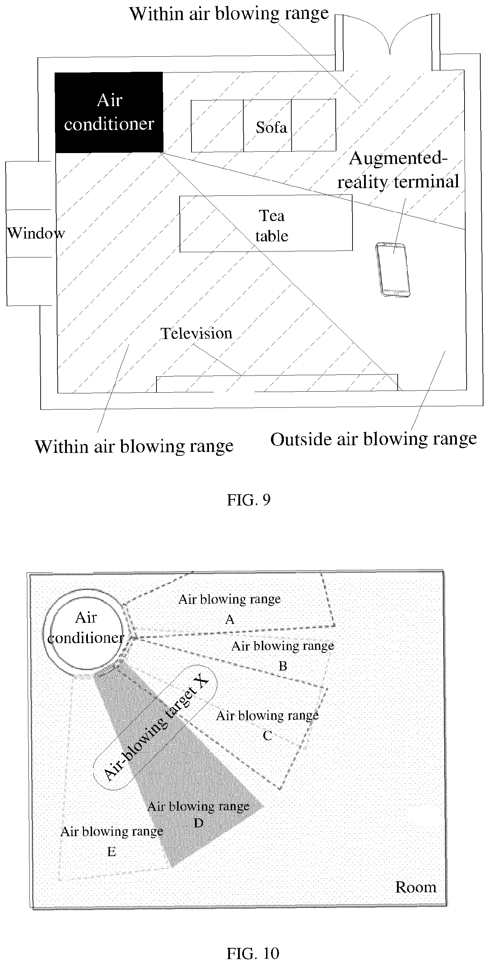

In an alternative application scene, the augmented reality terminal obtains its current position coordinate by means of the augmented-reality technology, and sends the position coordinate of the augmented reality terminal to the air conditioner. The air conditioner adjust its own air blowing angle according to the position coordinate of the augmented reality terminal and the air blowing mode of the air conditioner. The augmented reality terminal sends its own position coordinate to the air conditioner through an augmented-reality device provided in a wireless network, or directly through a wireless network. The wireless network includes, but is not limited to, a metropolitan area network, a local area network, and a wide area network. The connection manner includes, but is not limited to Bluetooth, Infrared, Zigbee, and the like. Alternatively, as shown in FIG. 8, when the air blowing mode of the air conditioner is the first air blowing mode, the air blowing angle of the air conditioner is adjusted according to the position coordinate of the augmented reality terminal, to make the coordinate of the augmented reality terminal to be located within the air blowing range of the air conditioner under measurement. The air blowing mode of the air conditioner at the moment is actually an air blowing mode of "wind-following-people". As shown in FIG. 9, when the air blowing mode of the air conditioner is the second air blowing mode, the air blowing angle of the air conditioner is adjusted according to the position coordinate of the augmented reality terminal, to make the coordinate of the augmented reality terminal to be located outside the air blowing range of the air conditioner under measurement. The air blowing mode of the air conditioner at the moment is actually an air blowing mode of "wind-avoiding-people".

In some embodiments, the above-mentioned method further includes, but is not limited to: determining a distance between the air conditioner and the augmented reality terminal; setting, when the distance exceeds a preset distance, the air blowing mode of the air conditioner to a third air blowing mode; setting, when the distance does not exceed the preset distance, the air blowing mode of the air conditioner to a fourth air blowing mode; where an air speed in the third air blowing mode is greater than an air speed in the fourth air blowing mode.

In an alternative application scene, the augmented reality terminal obtains the current position coordinate by means of the augmented-reality technology, and sends the position coordinate of the augmented reality terminal to the air conditioner. The air conditioner adjusts its own air blowing angle according to the position coordinate of the augmented reality terminal and the air blowing mode of the air conditioner. In general, the user always carries the augmented reality terminal with him/her, such as a pair of augmented-reality glasses, a mobile terminal phone having the augmented-reality application, or the like. The adjusting the air blowing mode of the air conditioner based on the distance between the air conditioner and the augmented reality terminal is equivalent to: determining the distance between the air conditioner and the user, and setting, when the distance exceeds the preset distance, the air blowing mode of the air conditioner to the third air blowing mode; setting, when the distance does not exceed the preset distance, the air blowing mode of the air conditioner to a fourth air blowing mode; where the air speed in the third air blowing mode is greater than the air speed in the fourth air blowing mode. It should be noted that, in a preferred technical solution, a temperature is also be included in the air blowing mode, for example, the temperature in the third air blowing mode is greater than the temperature in the fourth air blowing mode. Moreover, a humidity in the third air blowing mode is greater than a humidity in the fourth air blowing mode, which is only an example herein, but not a limitation to this embodiment.

In some embodiments, after the determining the air-blowing opening angle of the air conditioner according to the position change of the augmented reality terminal, the method further includes: determining, in the space coordinate system, a target coordinate of a target air-blowing position in the environment in which the air conditioner is located; determining a best placement position of the air conditioner according to the air-blowing opening angle of the air conditioner and the target coordinate. The target air-blowing position is located within the air blowing range of the air conditioner.

In an alternative application scene, the user cannot determine the best placement position for the air conditioner after purchasing the air conditioner. In order to solve this problem, a method for determining a best placement position for an air conditioner based on an air-blowing opening angle of the air conditioner is provided in some embodiments. A space coordinate system is established for the environment in which the air conditioner is to be placed, and the target air-blowing position in the environment in which the air conditioner is to be placed is determined, where the target air-blowing position includes, but is not limited to: a desk, a chair, a sofa, a bed, and the like. Moreover, the target air-blowing position can also be set by the user. The target coordinate in the space coordinate system is determined by the user setting the target air-blowing position in the environment in which the air conditioner is located. An air conditioner model of the air conditioner to be placed is introduced into the space coordinate system. The air conditioner model includes a volume of the air conditioner, a position of the air outlet, and the air-blowing opening angle. A display interface of the augmented reality terminal displays the air blowing range corresponding to the air-blowing opening angle of the air conditioner. After the target coordinate of the target air-blowing position falls within the air blowing range of the air conditioner, the position of the air conditioner is determined to be the best placement position. It should be noted that in the above-mentioned case, for the convenience of describing, the target air-blowing position is considered as a point. However, in an alternative application scene, some target air-blowing positions cannot be considered as a coordinate point simply. A model of an object at the target air-blowing position is created in the space coordinate system, and the best placement position of the air conditioner is determined according to a size of the model of the object at the target air-blowing position falling within the air blowing range of the air conditioner. The above description is only an example, but not a limitation to the embodiments.

In some embodiments, the determining the best placement position of the air conditioner according to the air-blowing opening angle of the air conditioner and the target coordinate, includes: adjusting a position coordinate of the air conditioner based on a position relationship between the air blowing range and the target coordinate; determining, when the target coordinate falls within the air blowing range, a current coordinate of the air conditioner in the space coordinate system to be the best placement position.

In some embodiments, the parameter information of the cabinet air conditioner is obtained through the augmented-reality application in the augmented reality terminal to create the air conditioner model. The position relationship of the air conditioner model is adjusted by determining the relationship between the air blowing range corresponding to the air-blowing opening angle of the air conditioner model and the target coordinate of the target air-blowing position. When the target coordinate of the target air-blowing position falls within the air blowing range of the air conditioner model, the current coordinate of the air conditioner model in the space coordinate system is determined to be the best placement position.

In some embodiments, when there are a plurality of target air-blowing positions in the environment in which the air conditioner is to be placed, the best placement position of the air conditioner model can be determined in two cases. In one case, when the plurality of target air-blowing positions all fall within the air blowing range of the air conditioner model, the current coordinate of the air conditioner model is determined to be the best placement position. In another case, after an assigned air-blowing position among the plurality of the target air-blowing positions falls within the air blowing range of the air conditioner model, the current coordinate of the air conditioner model is determined to be the best placement position.

In some embodiments, after the determining the air-blowing opening angle of the air conditioner according to the position change of the augmented reality terminal, the method further includes, but is not limited to: determining, in the space coordinate system, a coordinate of an air blowing target in the environment in which the air conditioner is located; determining a best placement angle of the air conditioner according to the placement position, the air-blowing opening angle, the position of the air outlet, and the coordinate of the air blowing target of the air conditioner. A target air-blowing position of the air blowing target is located within the air blowing range of the air conditioner. It should be noted that the position of the air outlet includes a position of the air conditioner where the air outlet is disposed, and a size of the air outlet.

In some embodiments, the air conditioner model is created on the basis of the parameter information of the cabinet air conditioner obtained by the augmented-reality application in the augmented reality terminal. The placement angle relationship of the air conditioner model is adjusted, by determining the relationship between the air blowing range corresponding to the air-blowing opening angle of the air conditioner model and the target coordinate of the air blowing target, and according to the placement position coordinate of the air conditioner model and the size and location of the air outlet, a distance that the air is blown out of the air conditioner, and the air blowing range corresponding to the air-blowing opening angle of the air conditioner. When the target coordinate of the target air-blowing position falls within the air blowing range of the air conditioner model, in the space coordinate system, the current coordinate of a heading position of the air outlet of the air conditioner model is determined to be the best placement angle. FIG. 10 is a schematic diagram illustrating the placement position of the cabinet air conditioner in the environment of a room, as shown in FIG. 10, the position of the air blowing target X and the position of the air conditioner are determined. The heading angle of the air outlet of the air conditioner is adjusted to make the air blowing target X falls within the air blowing range of the air conditioner. As shown in FIG. 10, the air blowing target X falls within the air blowing ranges B, C, D, and E; most of the air blowing target falls within the air blowing range D, and no part of the air blowing target X falls within the air blowing range A. It will be known thereby that the air blowing angle of the air conditioner corresponding to the air blowing range D is the best placement angle of the air conditioner, and the air blowing angle of the air conditioner corresponding to the air blowing range A is the worst placement angle of the air conditioner.

It should be noted that in the scene as shown in FIG. 10, the air blowing target is a region in the space coordinate system, rather than a space coordinate. In an alternative application scene, in a case that a volume of the air blowing target is negligible, the air blowing target can also be denoted by a space coordinate. The above description is only an example, but not a limitation to the embodiments.

According to the embodiments, the air conditioner and the environment in which the air conditioner is located are modeled by using the modeling method using the augmented-reality technology. Then, the air blowing range of the air conditioner is measured on the basis of the augmented reality terminal, thereby achieving the objective of determining the air blowing range of the air conditioner, determining the air-blowing opening angle of the air conditioner, and solving the technical problem in the prior art that certain functions of the air conditioner cannot be achieved because the air-blowing opening angle of the air conditioner cannot be accurately measured.

By means of the descriptions of the implementation mode, those skilled in the art can clearly know that the method according to the embodiments can be realized by appropriate means which can include software and a necessary general hardware platform. Certainly, the method can also be realized by appropriate means including hardware. However, the former is a better implementation mode under many conditions.

In the above-mentioned embodiments of the present invention, the description of each embodiment has its own focus. The parts that are not detailed in an embodiment, can be referred to the relevant description of other embodiments.

In the several embodiments provided in the present invention, it should be understood that the disclosed client software can be implemented in other ways.

The units described as separate components may or may not be physically separate, and the components illustrated as units may or may not be physical units, that is, they may be located in one place, or they may be distributed to a plurality of network units. Some or all of the units can be selected according to actual needs to achieve the object of the solutions of the embodiments.

### Industrial Applicability

In the embodiments of the present invention, according to the parameter information of the air conditioner and the image of the environment in which the air conditioner is located, the space coordinate system of the environment, in which the air conditioner is located, is established. The coordinates of the air conditioner and the augmented reality terminal in the space coordinate system are determined respectively. The air blowing angle of the air outlet of the air conditioner is adjusted. The augmented reality terminal is moved within the air blowing range of each maximum air blowing angle of the air outlet, so as to obtain the position change of the augmented reality terminal, thereby achieving the purpose of determining the air blowing range of the air conditioner, and determining the air-blowing opening angle of the air conditioner.

## Claims

1. A method for determining an air-blowing opening angle of an air conditioner (101), **characterized by** comprising:
establishing a space coordinate system of an environment, in which the air conditioner (101) is located, according to parameter information of the air conditioner and an image of the environment in which the air conditioner is located, wherein an image acquisition device of an augmented reality terminal (102) acquires the image of the environment in which the air conditioner is located;
determining coordinates of the air conditioner and the augmented reality terminal (102) in the space coordinate system respectively;
adjusting an air blowing angle of an air outlet of the air conditioner;
moving the augmented reality terminal within an air blowing range at each maximum air blowing angle of the air outlet, and obtaining a position change of the augmented reality terminal; and
determining an air-blowing opening angle of the air conditioner according to the position change of the augmented reality terminal.

2. The method of claim 1, wherein in an augmented-reality application of the augmented reality terminal, the establishing the space coordinate system of the environment, in which the air conditioner is located, according to the parameter information of the air conditioner and the image of the environment in which the air conditioner is located, comprises:
obtaining an image of the air conditioner and the image of the environment in which the air conditioner is located;
analyzing an air conditioner identifier in the image of the air conditioner, and obtaining the parameter information of the air conditioner, the parameter information being contained in the air conditioner identifier; and
establishing the space coordinate system according to the image of the environment in which the air conditioner is located.

3. The method of claim 1, wherein the adjusting the air blowing angle of the air outlet of the air conditioner, comprises:
determining, when each air blowing angle of the air conditioner arrives at a maximum, a position change of the augmented reality terminal within a current air blowing range of the air conditioner;
determining boundary coordinates of the augmented reality terminal within the air blowing range of each maximum air blowing angle of the air outlet; and
determining the air-blowing opening angle of the air conditioner based on the boundary coordinates of the augmented reality terminal within each maximum air blowing angle of the air outlet.

4. The method of any one of claims 1 to 3, wherein the method further comprises:
determining an air blowing mode of the air conditioner, the air blowing mode comprising a first air blowing mode and a second air blowing mode;
obtaining a current position coordinate of the augmented reality terminal;
adjusting, when the air blowing mode is the first air blowing mode, the air blowing angle of the air conditioner according to the position coordinate of the augmented reality terminal, making the position coordinate of the augmented reality terminal to be located within the air blowing range of the air conditioner; and
adjusting, when the air blowing mode is the second air blowing mode, the air blowing angle of the air conditioner according to the position coordinate of the augmented reality terminal, making the position coordinate of the augmented reality terminal to be located outside the air blowing range of the air conditioner.

5. The method of any one of claims 1 to 3, wherein the method further comprises:
determining a distance between the air conditioner and the augmented reality terminal;
setting, when the distance exceeds a preset distance, the air blowing mode of the air conditioner to a third air blowing mode; and
setting, when the distance does not exceed the preset distance, the air blowing mode of the air conditioner to a fourth air blowing mode;
wherein an air speed in the third air blowing mode is greater than an air speed in the fourth air blowing mode.

6. The method of claim 1, wherein after the determining the air-blowing opening angle of the air conditioner according to the position change of the augmented reality terminal, the method further comprises:
determining, in the space coordinate system, a target coordinate of a target air-blowing position in the environment in which the air conditioner is located; and
determining a best placement position of the air conditioner according to the air-blowing opening angle of the air conditioner and the target coordinate; wherein the target air-blowing position is located within the air blowing range of the air conditioner.

7. The method of claim 6, wherein the determining the best placement position of the air conditioner according to the air-blowing opening angle of the air conditioner and the target coordinate, comprises:
adjusting a position coordinate of the air conditioner based on a position relationship between the air blowing range and the target coordinate; and
determining, when the target coordinate falls within the air blowing range, a current coordinate of the air conditioner in the space coordinate system to be the best placement position.

8. The method of claim 1, wherein after the determining the air-blowing opening angle of the air conditioner according to the position change of the augmented reality terminal, the method further comprises:
determining, in the coordinate system, a coordinate of an air blowing target in the environment in which the air conditioner is located; and
determining a best placement angle of the air conditioner according a placement position of the air conditioner, the air-blowing opening angle, a position of the air outlet, and the coordinate of the air blowing target; wherein a target air-blowing position of the air blowing target is located within the air blowing range of the air conditioner.

9. The method of claim 5, wherein the air blowing mode comprises a temperature, and a temperature in the third air blowing mode is greater than a temperature in the fourth air blowing mode.

10. The method of claim 5, wherein a humidity in the third air blowing mode is greater than a humidity in the fourth air blowing mode.

## Patentansprüche

1. Verfahren zum Bestimmen eines Luftblasöffnungswinkels einer Klimaanlage (101), **dadurch gekennzeichnet, dass** das Verfahren umfasst:
Einrichten eines Raumkoordinatensystems einer Umgebung, in der sich die Klimaanlage (101) befindet, gemäß Parameterinformationen der Klimaanlage und einem Bild der Umgebung, in der sich die Klimaanlage befindet, wobei eine Bilderfassungsvorrichtung eines erweiterten Realitätsendgeräts (102) das Bild der Umgebung erfasst, in der sich die Klimaanlage befindet;
Bestimmen von Koordinaten der Klimaanlage bzw. des erweiterten Realitätsendgeräts (102) in dem Raumkoordinatensystem;
Anpassen eines Luftblaswinkels eines Luftauslasses der Klimaanlage;
Bewegen des erweiterten Realitätsendgeräts innerhalb eines Luftblasbereichs zu jedem maximalen Luftblaswinkel des Luftauslasses und Erhalten einer Positionsveränderung des erweiterten Realitätsendgeräts; und
Bestimmen des Luftblasöffnungswinkels der Klimaanlage gemäß der Positionsveränderung des erweiterten Realitätsendgeräts.

2. Verfahren nach Anspruch 1, wobei in einer erweiterten Realitätsanwendung des erweiterten Realitätsendgeräts das Einrichten des Raumkoordinatensystems der Umgebung, in der sich die Klimaanlage befindet, gemäß den Parameterinformationen der Klimaanlage und dem Bild der Umgebung, in der sich die Klimaanlage befindet, umfasst:
Erhalten eines Bildes der Klimaanlage und des Bildes der Umgebung, in der sich die Klimaanlage befindet;
Analysieren einer Klimaanlagenkennung in dem Bild der Klimaanlage und Erhalten der Parameterinformationen der Klimaanlage, wobei die Parameterinformationen in der Klimaanlagenkennung enthalten sind; und
Einrichten des Raumkoordinatensystems gemäß dem Bild der Umgebung, in der sich die Klimaanlage befindet.

3. Verfahren nach Anspruch 1, wobei das Anpassen des Luftblaswinkels des Luftauslasses der Klimaanlage umfasst:
Bestimmen, wenn jeder Luftblaswinkel der Klimaanlage an einem Maximum ankommt, einer Positionsveränderung des erweiterten Realitätsendgeräts innerhalb eines aktuellen Luftblasbereichs der Klimaanlage;
Bestimmen von Grenzkoordinaten des erweiterten Realitätsendgeräts innerhalb des Luftblasbereichs von jedem maximalen Luftblaswinkel des Luftauslasses; und
Bestimmen des Luftblasöffnungswinkels der Klimaanlage basierend auf den Grenzkoordinaten des erweiterten Realitätsendgeräts innerhalb jedes maximalen Luftblaswinkels des Luftauslasses.

4. Verfahren nach einem der Ansprüche 1 bis 3, wobei das Verfahren ferner umfasst:
Bestimmen eines Luftblasmodus der Klimaanlage, wobei der Luftblasmodus einen ersten Luftblasmodus und einen zweiten Luftblasmodus umfasst;
Erhalten einer aktuellen Positionskoordinate des erweiterten Realitätsendgeräts;
Anpassen, wenn der Luftblasmodus der erste Luftblasmodus ist, des Luftblaswinkels der Klimaanlage gemäß der Positionskoordinate des erweiterten Realitätsendgeräts, um zu veranlassen, dass sich die Positionskoordinate des erweiterten Realitätsendgeräts innerhalb des Luftblasbereichs der Klimaanlage befindet; und
Anpassen, wenn der Luftblasmodus der zweite Luftblasmodus ist, des Lustblaswinkels der Klimaanlage gemäß der Positionskoordinate des erweiterten Realitätsendgeräts, um zu veranlassen, dass sich die Positionskoordinate des erweiterten Realitätsendgeräts außerhalb des Luftblasbereichs der Klimaanlage befindet.

5. Verfahren nach einem der Ansprüche 1 bis 3, wobei das Verfahren ferner umfasst:
Bestimmen eines Abstands zwischen der Klimaanlage und dem erweiterten Realitätsendgerät;
Einstellen, wenn der Abstand einen voreingestellten Abstand überschreitet, des Luftblasmodus der Klimaanlage auf einen dritten Luftblasmodus; und
Einstellen, wenn der Abstand einen voreingestellten Abstand nicht überschreitet, des Luftblasmodus der Klimaanlage auf einen vierten Luftblasmodus;
wobei eine Luftgeschwindigkeit in dem dritten Luftblasmodus größer als eine Luftgeschwindigkeit in dem vierten Luftblasmodus ist.

6. Verfahren nach Anspruch 1, wobei das Verfahren, nach dem Bestimmen des Luftblasöffnungswinkels der Klimaanlage gemäß der Positionsveränderung des erweiterten Realitätsendgeräts, ferner umfasst:
Bestimmen, in dem Raumkoordinatensystem, einer Zielkoordinate einer Zielluftblasposition in der Umgebung, in der sich die Klimaanlage befindet; und
Bestimmen einer besten Platzierungsposition der Klimaanlage gemäß dem Luftblasöffnungswinkel der Klimaanlage und der Zielkoordinate; wobei sich die Zielluftblasposition innerhalb des Luftblasbereichs der Klimaanlage befindet.

7. Verfahren nach Anspruch 6, wobei das Bestimmen der besten Platzierungsposition der Klimaanlage gemäß dem Luftblasöffnungswinkel der Klimaanlage und der Zielkoordinate umfasst:
Anpassen einer Positionskoordinate der Klimaanlage basierend auf einer Positionsbeziehung zwischen dem Luftblasbereich und der Zielkoordinate; und
Bestimmen, wenn die Zielkoordinate in den Luftblasbereich fällt, einer aktuellen Koordinate der Klimaanlage in dem Raumkoordinatensystem als die beste Platzierungsposition.

8. Verfahren nach Anspruch 1, wobei das Verfahren, nach dem Bestimmen des Luftblasöffnungswinkels der Klimaanlage gemäß der Positionsveränderung des erweiterten Realitätsendgeräts, ferner umfasst:
Bestimmen, in dem Koordinatensystem, einer Koordinate eines Luftblasziels in der Umgebung, in der sich die Klimaanlage befindet; und
Bestimmen eines besten Platzierungswinkels der Klimaanlage gemäß einer Platzierungsposition der Klimaanlage, des Luftblasöffnungswinkels, einer Position des Luftauslasses und der Koordinate des Luftblasziels;
wobei sich eine Zielluftblasposition des Luftblasziels innerhalb des Luftblasbereichs der Klimaanlage befindet.

9. Verfahren nach Anspruch 5, wobei der Luftblasmodus eine Temperatur umfasst und wobei eine Temperatur in dem dritten Luftblasmodus größer als eine Temperatur in dem vierten Luftblasmodus ist.

10. Verfahren nach Anspruch 5, wobei eine Feuchtigkeit in dem dritten Luftblasmodus größer als eine Feuchtigkeit in dem vierten Luftblasmodus ist.

## Revendications

1. Procédé de détermination d'un angle d'ouverture de soufflage d'air d'un climatiseur (101), **caractérisé en ce qu'**il comporte les étapes consistant à :
établir un système de coordonnées spatiales d'un environnement dans lequel est situé le climatiseur (101), d'après des informations de paramètres du climatiseur et une image de l'environnement dans lequel est situé le climatiseur, un dispositif d'acquisition d'images d'un terminal (102) de réalité augmentée acquérant l'image de l'environnement dans lequel est situé le climatiseur ;
déterminer respectivement des coordonnées du climatiseur et du terminal (102) de réalité augmentée dans le système de coordonnées spatiales ;
régler un angle de soufflage d'air d'une sortie d'air du climatiseur ;
déplacer le terminal de réalité augmentée à l'intérieur d'une plage de soufflage d'air à chaque angle maximum de soufflage d'air de la sortie d'air, et obtenir un changement de position du terminal de réalité augmentée ; et
déterminer un angle d'ouverture de soufflage d'air du climatiseur d'après le changement de position du terminal de réalité augmentée.

2. Procédé selon la revendication 1, dans une application de réalité augmentée du terminal de réalité augmentée, l'établissement du système de coordonnées spatiales de l'environnement dans lequel est situé le climatiseur, d'après les informations de paramètres du climatiseur et l'image de l'environnement dans lequel est situé le climatiseur, comportant les étapes consistant à :
obtenir une image du climatiseur et l'image de l'environnement dans lequel est situé le climatiseur ;
analyser un identifiant de climatiseur dans l'image du climatiseur, et obtenir les informations de paramètres du climatiseur, les informations de paramètres étant contenues dans l'identifiant de climatiseur ; et
établir le système de coordonnées spatiales d'après l'image de l'environnement dans lequel est situé le climatiseur.

3. Procédé selon la revendication 1, le réglage de l'angle de soufflage d'air de la sortie d'air du climatiseur comportant les étapes consistant à :
déterminer, lorsque chaque angle de soufflage d'air du climatiseur arrive à un maximum, un changement de position du terminal de réalité augmentée à l'intérieur d'une plage actuelle de soufflage d'air du climatiseur ;
déterminer des coordonnées de limites du terminal de réalité augmentée à l'intérieur de la plage de soufflage d'air de chaque angle maximum de soufflage d'air de la sortie d'air ; et
déterminer l'angle d'ouverture de soufflage d'air du climatiseur d'après les coordonnées de limites du terminal de réalité augmentée à l'intérieur de chaque angle maximum de soufflage d'air de la sortie d'air.

4. Procédé selon l'une quelconque des revendications 1 à 3, le procédé comportant en outre les étapes consistant à :
déterminer un mode de soufflage d'air du climatiseur, le mode de soufflage d'air comportant un premier mode de soufflage d'air et un deuxième mode de soufflage d'air ;
obtenir une coordonnée de position actuelle du terminal de réalité augmentée ;
régler, lorsque le mode de soufflage d'air est le premier mode de soufflage d'air, l'angle de soufflage d'air du climatiseur d'après la coordonnée de position du terminal de réalité augmentée, en faisant en sorte que la coordonnée de position du terminal de réalité augmentée soit située à l'intérieur de la plage de soufflage d'air du climatiseur ; et
régler, lorsque le mode de soufflage d'air est le deuxième mode de soufflage d'air, l'angle de soufflage d'air du climatiseur d'après la coordonnée de position du terminal de réalité augmentée, en faisant en sorte que la coordonnée de position du terminal de réalité augmentée soit située en dehors de la plage de soufflage d'air du climatiseur.

5. Procédé selon l'une quelconque des revendications 1 à 3, le procédé comportant en outre les étapes consistant à :
déterminer une distance entre le climatiseur et le terminal de réalité augmentée ;
régler, lorsque la distance dépasse une distance prédéfinie, le mode de soufflage d'air du climatiseur sur un troisième mode de soufflage d'air ; et
régler, lorsque la distance ne dépasse pas la distance prédéfinie, le mode de soufflage d'air du climatiseur sur un quatrième mode de soufflage d'air ;
une vitesse de l'air dans le troisième mode de soufflage d'air étant supérieure à une vitesse de l'air dans le quatrième mode de soufflage d'air.

6. Procédé selon la revendication 1, le procédé comportant en outre, après la détermination de l'angle d'ouverture de soufflage d'air du climatiseur d'après le changement de position du terminal de réalité augmentée, les étapes consistant à :
déterminer, dans le système de coordonnées spatiales, une coordonnée cible d'une position cible de soufflage d'air dans l'environnement dans lequel est situé le climatiseur ; et
déterminer une meilleure position de placement du climatiseur d'après l'angle d'ouverture de soufflage d'air du climatiseur et la coordonnée cible; la position cible de soufflage d'air étant située à l'intérieur de la plage de soufflage d'air du climatiseur.

7. Procédé selon la revendication 6, la détermination de la meilleure position de placement du climatiseur d'après l'angle d'ouverture de soufflage d'air du climatiseur et la coordonnée cible, comportant les étapes consistant à :
régler une coordonnée de position du climatiseur sur la base d'une relation de position entre la plage de soufflage d'air et la coordonnée cible ; et
déterminer, lorsque la coordonnée cible tombe à l'intérieur de la plage de soufflage d'air, une coordonnée actuelle du climatiseur dans le système de coordonnées spatiales comme étant la meilleure position de placement.

8. Procédé selon la revendication 1, le procédé comportant en outre, après la détermination de l'angle d'ouverture de soufflage d'air du climatiseur d'après le changement de position du terminal de réalité augmentée, les étapes consistant à :
déterminer, dans le système de coordonnées, une coordonnée d'une cible de soufflage d'air dans l'environnement dans lequel est situé le climatiseur ; et
déterminer un meilleur angle de placement du climatiseur d'après une position de placement du climatiseur, l'angle d'ouverture de soufflage d'air, une position de la sortie d'air, et la coordonnée de la cible de soufflage d'air;
une position cible de soufflage d'air de la cible de soufflage d'air étant située à l'intérieur de la plage de soufflage d'air du climatiseur.

9. Procédé selon la revendication 5, le mode de soufflage d'air comportant une température, et une température dans le troisième mode de soufflage d'air étant supérieure à une température dans le quatrième mode de soufflage d'air.

10. Procédé selon la revendication 5, une humidité dans le troisième mode de soufflage d'air étant supérieure à une humidité dans le quatrième mode de soufflage d'air.
